# EUROPEAN PATENT APPLICATION

(11) **EP 4 708 890 A1**
(43) Date of publication of application: **11.03.2026**
(21) Application number: 24797399.3
(22) Date of filing: 24.04.2024
(51) Int. Cl.: H04N 23/54, H04N 23/55, H04N 23/57, H05K 1/18

(54) **IMAGE SENSOR MODULE, CAMERA MODULE, AND MANUFACTURING METHOD THEREOF**

(30) Priority: 27.04.2023 KR 20230055718
(71) Applicant: LG INNOTEK CO. LTD, Gangseo-gu Seoul 07796 (KR)
(72) Inventor: CHOI, Byung Hyun, Seoul 07796 (KR)
(74) Representative: M. Zardi & Co S.A.
(86) International application number: PCT/KR2024/005530
(87) International publication number: WO 2024/225744

(57) **Abstract**

An image sensor module disclosed in an embodiment includes an image sensor; an image signal processing chip that interfaces with the image sensor; a main substrate having one surface on which the image sensor is mounted and the other surface on which the image signal processing chip is mounted; an adhesive member between the main substrate and the image sensor; and a first substrate bonded to the other surface of the main substrate, wherein the first substrate includes a receiving hole extending from the other surface to the one surface, and the image signal processing chip may be connected to the other surface of the main substrate through the receiving hole of the first substrate.

## Description

### [Technical Field]

An embodiment relates to an image sensor module and a camera module having the same.

An embodiment relates to an image sensor module and a method for manufacturing the same.

### [Background Art]

Generally, image sensor may be broadly divided into CCD (Charge couple device) image sensor and CMOS (Complementary metal-oxide semiconductor) image sensor. CMOS image sensor converts optical signals into electrical signals using the CMOS process. Compared to CCD image sensor, CMOS image sensor is simpler to operate. The circuitry for processing the electrical signals output from pixels may be integrated into a single chip using the CMOS process, enabling miniaturization. The use of the CMOS process also reduces manufacturing costs and power consumption. Furthermore, a method is being used that integrates a pixel array, an analog-to-digital converter (ADC) that converts the analog signals output from the pixel array into digital signals, and an Image signal processor (ISP) that processes the digital signals output from the ADC into image signals.

However, when the CMOS image sensor and the ISP are implemented on a single chip using the same substrate, digital noise generated by the ISP can affect the CMOS image sensor.

### [Disclosure]

### [Technical Problem]

An embodiment of the invention provides an image sensor module, in which an image signal processing chip and a first substrate are mounted on a lower surface of a main substrate on which an image sensor is mounted, and a method for manufacturing the same.

An embodiment of the invention provides an image sensor module, in which a bottom pin map on a lower portion of the main substrate is disposed on a region vertically overlapping the image sensor, and a method for manufacturing the same.

An embodiment of the invention provides an image sensor module, in which an image sensor is mounted on an upper portion of the main substrate and an image signal processing chip is mounted on a lower portion of the main substrate via a first substrate, thereby simplifying the interface between the image sensor and the image signal processing chip, and a method for manufacturing the same.

An embodiment of the invention provides a camera module, in which an image sensor is mounted on an upper portion of the main substrate and an image signal processing chip is mounted on a lower portion of the main substrate via a first substrate, and a second substrate having a connector is disposed under the first substrate, and a method for manufacturing the same.

### [Technical Solution]

An image sensor module according to an embodiment of the invention comprises: an image sensor; an image signal processing chip interfacing with the image sensor; a main substrate having one surface on which the image sensor is mounted and the other surface on which the image signal processing chip is mounted; an adhesive member between the main substrate and the image sensor; and a first substrate bonded to the other surface of the main substrate, wherein the first substrate includes a receiving hole extending from the other surface to the one surface, and the image signal processing chip may be connected to the other surface of the main substrate through the receiving hole of the first substrate.

According to an embodiment of the invention, the image sensor module further comprises a memory disposed on one side of the receiving hole, and the memory may be connected to the other surface of the main substrate through the receiving hole. According to an embodiment of the invention, the module further comprises an electronic component disposed on at least one side of the receiving hole, and the electronic component may be connected to the other surface of the main substrate through the receiving hole.

According to an embodiment of the invention, the image sensor module further comprises an oscillator disposed on one side of the receiving hole, and the oscillator may be connected to the other surface of the main substrate through the receiving hole. According to an embodiment of the invention, the image signal processing chip may be a serializer IC. According to an embodiment of the invention, the image signal processing chip may be spaced apart from the lower surface of the first substrate. A camera module according to an embodiment of the invention includes an image sensor; an image signal processing chip interfacing with the image sensor; a main substrate having one surface on which the image sensor is mounted and the other surface on which the image signal processing chip is mounted; an adhesive member between the main substrate and the image sensor; a first substrate bonded to the other surface of the main substrate; a second substrate bonded to the other surface of the first substrate; and a power module and a connector connected to the other surface of the second substrate, wherein the first substrate includes a receiving hole extending from the other surface to the one surface, and the image signal processing chip may be connected to the other surface of the main substrate through the receiving hole of the first substrate.

According to an embodiment of the invention, the camera module may include a lens barrel disposed around the upper periphery of the second substrate and having a plurality of lenses therein. According to an embodiment of the invention, the second substrate may further include a memory or an oscillator disposed on one side of the receiving hole, wherein the memory or oscillator may be connected to the other surface of the main substrate through the receiving hole. According to an embodiment of the invention, the second substrate may further include an electronic component disposed on at least one side of the receiving hole, wherein the electronic component may be connected to the other surface of the main substrate through the receiving hole.

According to an embodiment of the invention, the image signal processing chip is a serializer IC, and the image signal processing chip and the image sensor may directly interface through the main substrate. According to an embodiment of the invention, the thickness of the first substrate may be greater than that of the main substrate, the thickness of the second substrate may be greater than that of the first substrate, and the length of at least one side of the second substrate may be greater than that of at least one side of the first substrate.

### [Advantageous Effects]

According to an embodiment of the invention, since the image signal processing chip (Serializer IC) and the image sensor are mounted on opposite sides of the main substrate, a substrate for the image signal processing chip may be eliminated, and the interface may be simplified, improving the reliability of the image sensor module.

Furthermore, according to an embodiment of the invention, since the image signal processing chip is received through a receiving hole in the first board and mounted on the main substrate, the internal structure of the camera may be designed to be smaller than before, while substrate specifications may be relaxed and price competitiveness may be secured.

According to an embodiment of the invention, by mounting the image sensor and image signal processing chip on the main substrate, the main substrate may be shared, and since a separate image sensor reinforcement process is not required during the final camera assembly process, the overall assembly process may be simplified. Furthermore, the SiP (System in Package) module may be platformized because it can be connected to a main substrate configured with the same pin map, even when the type of image sensor is changed.

### [Description of Drawings]

FIG. 1 is an example of a side cross-sectional view of a camera module having an image sensor module according to an embodiment of the invention.
FIG. 2 is an example of a bottom view of the image sensor module of FIG. 1.
FIG. 3 is a block diagram illustrating the interface between the image sensor and the image signal processing chip of FIG. 1.
FIG. 4 (a)(b) is diagrams illustrating a manufacturing process of the image sensor module.
FIG. 5 is a side cross-sectional view of a camera module in which an image sensor module and a connector module are combined according to an embodiment of the invention.
FIG. 6 (a)(b) are a first variation showing a side cross-sectional view and a rear view of the image sensor module of FIG. 1.
FIG. 7 (a)(b) are a second variation showing a side cross-sectional view and a rear view of the image sensor module of FIG. 1.
FIG. 8 (a) is a perspective view of a camera module according to an embodiment of the invention, and (b)(c) are front views of examples of main substrates on which different image sensors are mounted.
FIG. 9 is a plan view of a vehicle to which a camera module according to an embodiment of the invention is applied.

### [Best Mode]

The technical idea of the present invention is not limited to some of the described embodiments, but can be implemented in various different forms, and if it is within the scope of the technical idea of the present invention, one or more of its components may be selectively combined and substituted between embodiments. In addition, terms (including technical and scientific terms) used in the embodiments of the present invention, unless explicitly specifically defined and described, may be interpreted as a meaning that may be generally understood by those skilled in the art to which the present invention belongs, and terms generally used, such as terms defined in the dictionary, may be interpreted in consideration of the context of the related technology.

Terms used in the embodiments of the present invention are for describing the embodiments and are not intended to limit the present invention. In the present specification, the singular form may include a plural form unless specifically described in the phrase, and may include at least one of all combinations that may be combined as A, B, and C when described as "A and/or at least one (or more than one) of B and C". Also, terms such as first, second, A, B, (a), and (b) may be used to describe components of an embodiment of the present invention. These terms are intended only to distinguish the components from other components and are not determined by their nature, sequence, or order. Also, when a component is described as being 'connected', 'coupled' or 'connected' to another component, not only when the component is directly connected, coupled or connected to another component, it may also be 'connected', 'coupled', or 'connected' due to another component between that component and the other component. In addition, when each component is described as being formed or disposed "up (above) or down (bottom)", the up (down) or down (bottom) includes not only when two components are in direct contact with each other, but also when one or more components are formed or disposed between two components. Also, when expressed as "up (above) or down (bottom)", it may include the meaning of not only the upward direction but also the downward direction based on one component. Hereinafter, the upper surface of each substrate may be one side of each substrate, and the lower surface of each substrate may be the opposite side of each side of each substrate.

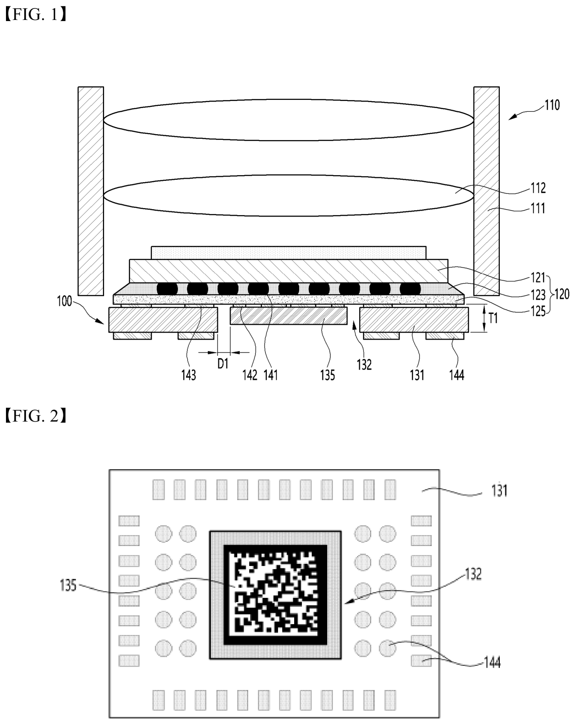

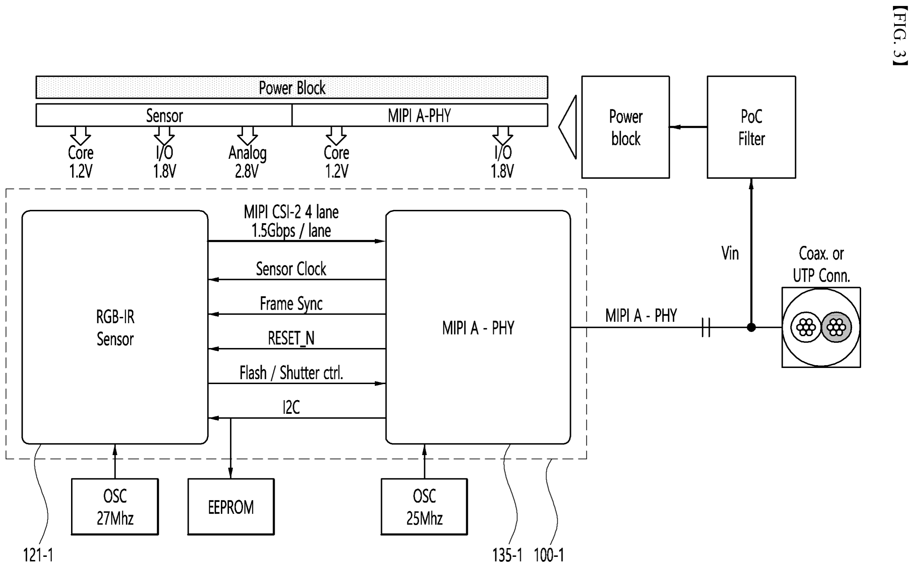

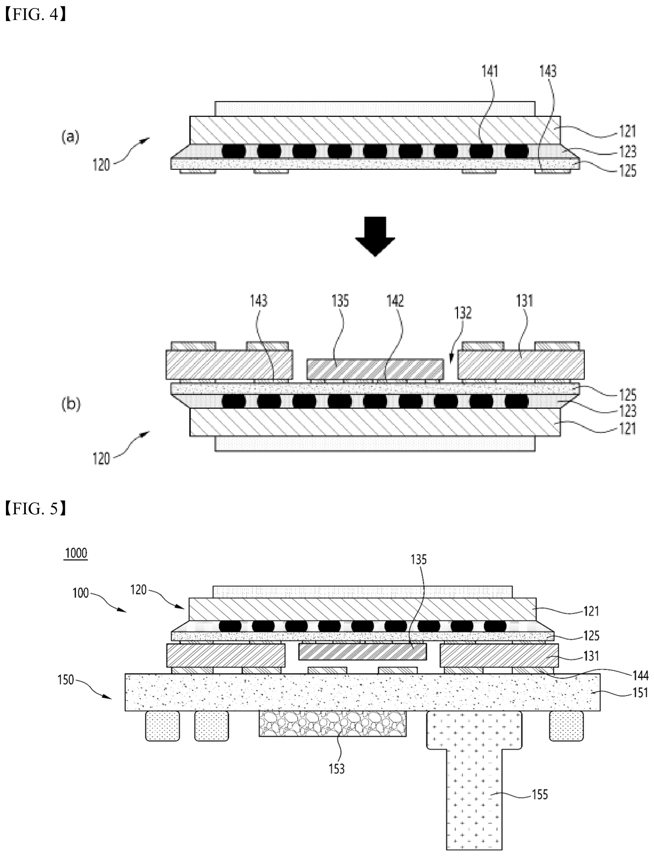

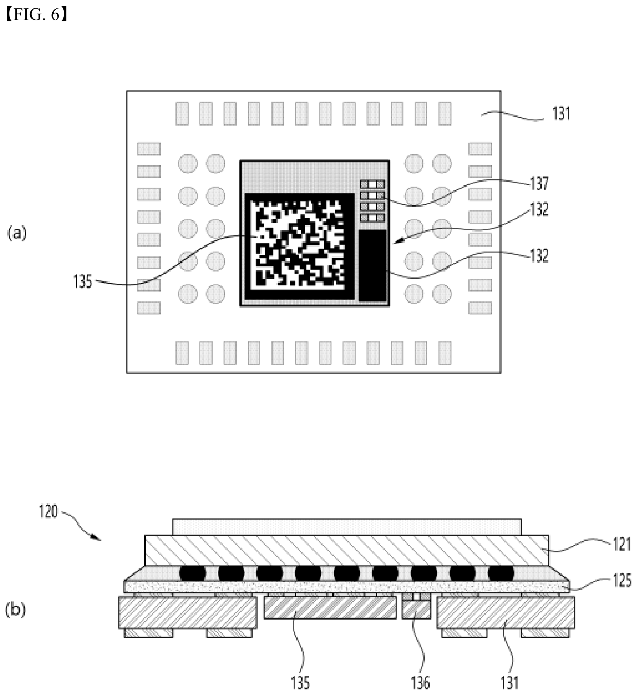

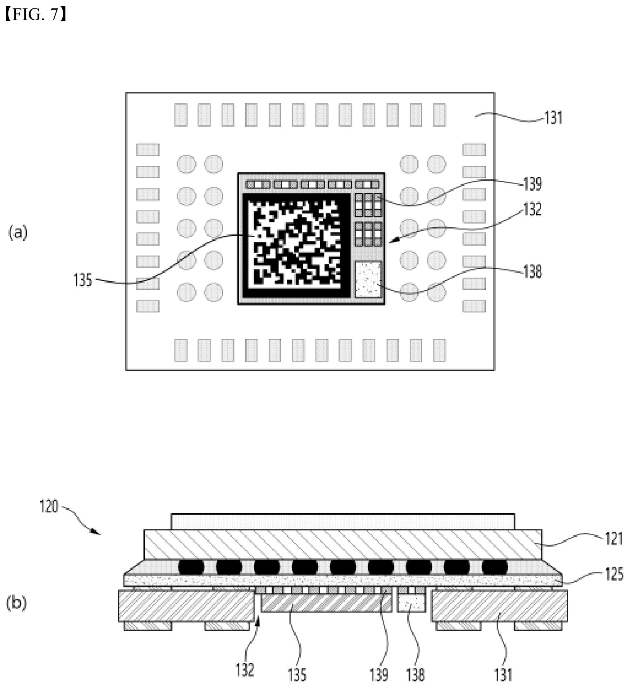

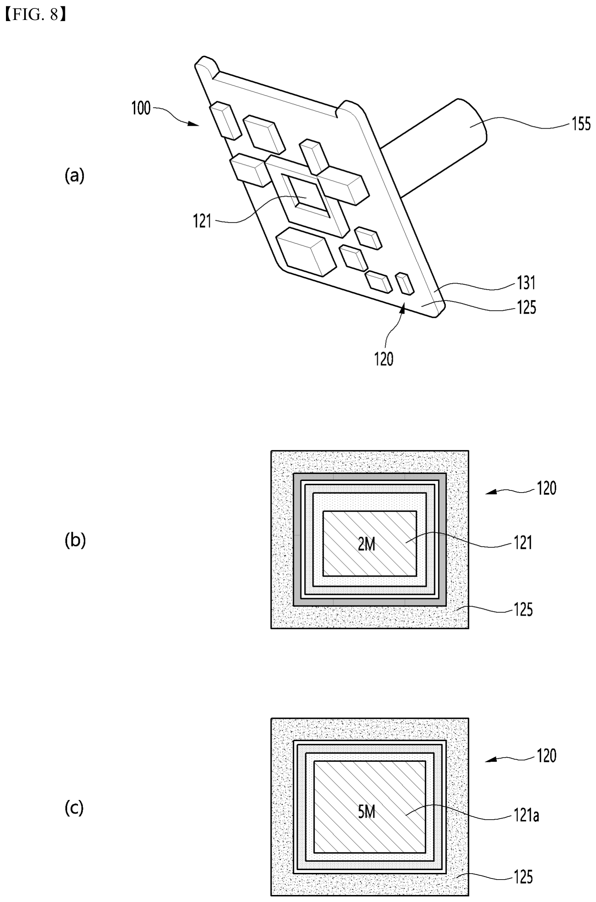

Hereinafter, preferred embodiments of the present invention will be described in detail with reference to the attached drawings. FIG. 1 is an example of a side cross-sectional view of a camera module having an image sensor module according to an embodiment of the invention, FIG. 2 is an example of a bottom view of the image sensor module of FIG. 1, FIG. 3 is a block diagram showing an interface between the image sensor of FIG. 1 and an image signal processing chip, FIG. 4(a)(b) is diagrams showing a manufacturing process of the image sensor module, FIG. 5 is a side cross-sectional view of a camera module in which an image sensor module and a connector module are combined according to an embodiment of the invention, FIG. 6(a)(b) is a first modified example showing a side cross-sectional view and a back example of the image sensor module of FIG. 1, FIG. 7(a)(b) is a second modified example showing a side cross-sectional view and a back example of the image sensor module of FIG. 1, FIG. 8(a) is a perspective view of a camera module according to an embodiment of the invention, and FIG. 8(b)(c) are front views of examples of main substrates on which different image sensors are mounted.

Referring to FIGS. 1 and 2, a camera module 1000 according to an embodiment of the invention includes an image sensor portion 100 and a lens portion 110. The image sensor portion 100 may include an image sensor module 120 equipped with an image sensor 121 and an image signal processing chip 135. The image sensor portion 100 includes a first substrate 131 through which the image signal processing chip 135 passes.

The lens portion 110 includes a lens barrel 111 having a plurality of lenses 112 aligned along an optical axis. The number of lenses 112 may be two or more, for example, from 2 to 10 or from 3 to 7. The lens barrel 111 may be combined into one or more lenses. In the case of multiple lens barrels, it may include an object-side barrel or a sensor-side barrel. The object-side barrel or the sensor-side barrel may move at least one lens along the optical axis using an actuator.

The image sensor module 120 includes a main substrate 125 and an image sensor 121 mounted on the main substrate 125. The image sensor module 120 may include a first substrate 131 and an image signal processing chip 135.

The image sensor 121 is bonded to the upper surface of the main substrate 125 using a bonding member 141 and is electrically connected to the main substrate 125. An adhesive member 123 is disposed between the image sensor 121 and the main substrate 125. The adhesive member 123 protects the perimeter of the bonding member 141 and may adhere the image sensor 121 to the main substrate 125. The adhesive member 123 may be a resin material, such as silicone or epoxy, or a thermally conductive insulating material.

The main substrate 125 may be a printed circuit board (PCB). The main substrate 125 may be formed as a single layer or multiple layers, and if multilayered, may include via holes therein. The main substrate 125 may be a flexible or rigid PCB. The main substrate 125 may include one or more via holes penetrating the main substrate 125. The image signal processing chip 135 may be electrically connected to the image sensor 121 disposed on the main substrate 125 through a via hole. Electronic components such as resistors may be electrically connected to each other on the main substrate 125.

The image sensor 121 may be any one of a CCD (Charge coupled device), a CMOS (Complementary metal oxide semiconductor), a CPD, and a CID. The image sensor 121 may include an RGB (red, green, blue)-IR sensor. The horizontal and/or vertical lengths of unit pixels (R, G, B, IR pixels) of the image sensor 121 may be 2 um (micrometers) or less. In addition, as the number of pixels increases, the overall size of the image sensor 121 may increase. Accordingly, the image sensor 121 may be applied to a camera module 1000 having a high number of pixels and/or pixels. The image sensor 121 may be bonded to the main substrate 125 using flip-chip technology. Flip-chip technology is a method of wireless bonding, which is a type of device mounting technology, and is a technology that fuses a chip to a substrate using a bonding member 141, such as a lead bump, which serves as an electrode on the bottom of the chip, without using an additional connecting structure such as a metal lead (wire) or an intermediate medium such as a ball grid array (BGA). This technology has the advantage of being compact and lightweight, with the package being the same size as the chip, having excellent thermal stability, high current application rate, and high response speed, and has the effect of making the distance between electrodes much finer.

The first substrate 131 may be a printed circuit board (PCB). The first substrate 131 may be formed as a single layer or multiple layers, and in the case of multiple layers, it may include via holes. The first substrate 131 may be a flexible or rigid PCB. The first substrate 131 may be a double-sided PCB in which pads 143 and 144 are exposed on both sides. The first substrate 131 may include one or more via holes penetrating the first substrate 131 and may be electrically connected to the main substrate 125. The first substrate 131 may include upper pads 143 and lower pads 144, and the upper pads may be electrically connected to the main substrate 125. The first substrate 131 may include a receiving hole 132 therein, and the receiving hole 132 may penetrate from the lower surface to the upper surface of the first substrate 131. The size of the receiving hole 132 may be larger than the bottom surface area of the image signal processing chip 135, for example, 1.2 times or more, and preferably, 1.2 to 2 times or less, or 1.2 to 1.8 times. If the size of the receiving hole 132 is smaller than the above area, insertion of the image signal processing chip 135 may be difficult, and if it is larger than the above range, the rigidity of the first substrate 131 may be reduced. As shown in FIG. 2, the shape of the receiving hole 132 may be polygonal, and the first substrate 131 may be arranged around the outer perimeter of the receiving hole 132.

The thickness of the first substrate 131 may be thicker than the thickness of the main substrate 125. The length of at least one side of the first substrate 131 may be greater than the length of at least one side of the main substrate 125.

The depth T1 of the receiving hole 132 may be equal to or greater than the thickness of the first substrate 131. The depth T1 of the receiving hole 132 may be 1.5 mm or less. The distance D1 between the receiving hole 132 and at least one inner surface of the first substrate 131 may be 0.5 mm or less, for example, in the range of 0.2 mm to 0.5 mm. Due to the depth T1 of the receiving hole 132, the image signal processing chip 135 may be disposed at a position spaced apart from the lower surface of the first substrate 131.

The image signal processing chip 135 is connected to the lower pads 142 of the main substrate 125 and may be electrically connected to the main substrate 125. The image signal processing chip 135 may be flip-bonded to the lower pads 142 of the main substrate 125. Electronic components such as resistors may be electrically connected to each other on the first substrate 131. As shown in FIG. 2, a plurality of the lower pads 142 may be arranged in the first direction and the second direction along the between the receiving hole 132 and the substrate edge. When the image signal processing chip 135 is received within the first substrate 131, the thickness of the first substrate 131 may be reduced, the image signal processing chip 135 may be omitted from being mounted within the first substrate 131, the number of soldering points required for internal mounting may be reduced, and the rigidity of the substrate may be prevented from being reduced due to the formation of a groove for embedding. In addition, the price of the first substrate 131 may be lowered, i.e., a low-cost substrate may be used.

The image signal processing chip 135 is inserted within the first substrate 131, mounted on the lower surface of the main substrate 125, and electrically connected to the image sensor 121. Accordingly, the bottom pin map of the main substrate 131 may be designed independently of the image sensor 121 located above, and the first substrate 131 may be used for various purposes. That is, since the first substrate 131 does not require the image signal processing chip 135 to be embedded within, it may be selected from a variety of substrate types and provided with a thinner thickness.

The image signal processing chip 135 may be any one of interfaces using the LVDS (Low Voltage Differential Signaling), V-By-One HS protocol, an interface that transmits five or more signals over a single cable (HD Base T), a MIPI A-PHY chipset, or a SerDes (Serializer-Deserializer). The image signal processing chip 135 may be any one of various communication interfaces and may be in the form of a chip, component, or electronic component. The SerDes (Serializer-Deserializer) handles the serialization and deserialization functions used in high-speed communication between chips.

The image signal processing chip 135 includes a serializer IC as shown in FIG. 3, and the serializer IC is an interface that provides a high-performance link between the image sensor 121 and the display and related electronic control units (ECUs) in the vehicle, and may be defined as MIPI (Mobile industry processor interface) A-PHY (physical). MIPI is an interface specification for processors and peripheral devices including AP (Application Processor) established by the MIPI Alliance, which was established by Intel, ARM, Nokia, Samsung, ST, TI, etc. to strengthen reuse and compatibility in mobile and Internet of Things devices. The standards set by MIPI include MIPI D-PHY, MIPI M-PHY, MIPI C-PHY, etc. In particular, MIPI A-PHY may be used when transmitting data at high speed between a camera, a display, and a related domain ECU. MIPI A-PHY has a low error rate, high stability, and high resilience even in automotive environments, enabling it to be used over long distances and improving data rates.

The image sensor portion 100 simplifies the interface between the image sensor 121 and the image signal processing chip 135 by modularizing the image sensor 121 and the image signal processing chip 135 into a System-in-Package (SIP), thereby reducing the number of connectors and signal pins. The interface may include a symmetrical or asymmetrical interface. The image sensor portion 100 may be applied to applications such as Advanced driver assistance systems (ADAS), digital cockpits, in-vehicle infotainment (IVI), and autonomous driving systems (ADS). That is, the image sensor portion 100 may be applied to next-generation applications utilizing camera and display technology, including high-performance instrument panels and infotainment displays in vehicles, internal driver and passenger monitoring systems, virtual side mirrors, and other ADAS, IVI (In-Vehicle Infotainment), and ADS applications.

The image signal processing chip 135 includes a serial converter and is configured to convert various parallel signals into serial signals. Specifically, the image signal processing chip 135 receives parallel data from a large number of signal pins, converts it into serial data, and outputs it through a small number of signal pins. This allows a single pin to perform multiple functions, thereby reducing the overall pin count.

The RGB-IR Sensor, which is the image sensor 121, and the MIPI A-PHY, a type of serializer IC, communicate through multiple pins. In the past, the image sensor and the serializer were arranged on separate substrates, requiring a flexible substrate to connect each substrate. However, the SiP (system in package) module, which is the image sensor portion 100 according to the embodiment, mounts the image sensor 121 on the upper surface of the main substrate 125 and mounts the serializer IC on the lower surface of the main substrate 125, thereby electrically connecting the image sensor 121 and the serializer to form a module.

The image sensor 121 and the image signal processing chip 135 may be connected to a high-speed interface (MIPI CSI-2.4 lane), a sensor clock, a frame sync, a reset (Reset_N), a fresh/shutter signal (flash/shutter ctrl), and a serial communication (I2C) pin, and are connected to various memories (EEPROM) and an oscillator (OSC) in the vicinity. Additionally, the image sensor 121 and the image signal processing chip 135 can receive various power supplies from a power block. Furthermore, a high-frequency filter (Poc coax) filters all current transmitted through the cable to transmit it to an appropriate frequency band. One or more image sensors 121 may be mounted on the upper surface of the main substrate 125. The image signal processing chip 135 and other signal processing chips may be further mounted on the lower surface of the main substrate 125. The receiving hole 132 in which the image signal processing chip 135 is disposed may be sealed with a heat-conductive material containing a heat-dissipating agent within an insulating material, such as epoxy or resin.

As shown in FIG. 4(a)(b), the image sensor 121 is mounted on the main substrate 125 using a bonding member 141 such as a solder ball, and an adhesive member 123 is formed around the bonding member 141 and between the main substrate 125 and the image sensor 121. The main substrate 125 has pads 143A formed on the lower portion. The first substrate 131 forms a receiving hole 132 therein and is bonded to the pads 143A and 143 on the main substrate 125. Here, the image signal processing chip 135 may be mounted on the main substrate 125 before the first substrate 131 is mounted on the main substrate 125. As another example, the image signal processing chip 135 may be mounted on the main substrate 125 after the first substrate 131 is mounted on the main substrate 125.

As shown in FIG. 5, when the first substrate 131 is connected to the main substrate 125, it may be connected to the second substrate 151 through the lower pads 144 of the first substrate 131. The second substrate 151 may be a connector substrate, and may have electronic components such as resistors arranged at the lower portion thereof, a PMIC (Power module IC), which is a power module 153, and a connector 155.

A camera substrate portion 150 may include a second substrate 151, a power module 153, and a connector 155. The lens barrel 111 of FIG. 1 may be mounted and supported on the second substrate 151. The thickness of the second substrate 151 may be thicker than the thickness of the first substrate 131. The length of at least one side of the second substrate 151 may be greater than the length of at least one side of the first substrate 131. The upper periphery of the second substrate 151 may be exposed to vertically overlap with the lens barrel 111.

The power module 153 may be coupled to the second substrate 151. The power module 153 may be a converter. The power module 153 converts the power level received from an external device (not shown) to the power level required by the board and outputs power having the converted level to each electronic component. For example, the power module 153 may include at least one of a DC-DC converter (not shown) or a low voltage drop-out (LDO) regulator (not shown). The connector 155 may be coupled to the second substrate 151. The connector 155 may be electrically connected to the second substrate 151. The connector 155 may supply external power to the camera device. The connector 155 may include a port for electrical connection to the external device. The cross-section of the connector 155 may be formed in a circular shape. Alternatively, the cross-section of the connector 155 may be variously modified, such as to have an oval or rectangular shape.

The second substrate 151 may be spaced apart from the lower surface of the image signal processing chip 135. A heat dissipation member may be further disposed on the upper surface of the second substrate 151 in a region that vertically overlaps the image signal processing chip 135, thereby dissipating heat generated from the image signal processing chip 135. The second substrate 151 may include a single-layer or multi-layer PCB, and may be made of a flexible or rigid material. The second substrate 151 may have pads on the upper surface and may be electrically connected to the pads of the first substrate 131. The second substrate 151 may have via holes therein.

The connector 155 and power module 153 connect the main substrate 125 equipped with the image sensor 121 via the second substrate 151 and the first substrate 131. Thus, the second substrate 151 and the main substrate 125 may be connected via the first substrate 131, enabling power supply and high-speed communication. This eliminates the need for separate cables (power cables and high-speed signal lines) connecting the main substrate 125 and the second substrate 151, reduces the cable bonding process, and prevents cable bonding failures.

Furthermore, since the main substrate 125 and the second substrate 151 are tightly bonded with the first substrate 131 interposed therebetween, the thickness of the camera module may be reduced, enabling miniaturization. In addition, since the second substrate 131 fixes the positions of the main substrate 125 and the second substrate 151, a separate member for fixing the second substrate 131 may not be installed.

FIG. 6(a)(b) is a first modified example showing a rear view of the first substrate and a side cross-section of the image sensor portion according to an embodiment. As shown in FIG. 6, the image sensor portion may further include an image signal processing chip 135, at least one or all of a memory 136, and an electronic component 147 within the receiving hole 132 of the first substrate 131. The memory 136 is an EEPROM, and the electronic component 147 may include a passive or active component, for example, a plurality of capacitors. The memory 136 and electronic components 147 may be electrically connected to the main substrate 125 through the receiving hole 132 of the first substrate 131. Therefore, the memory 136 and electronic components 147 for SerDes (Serializer/Deserializer) operation may be arranged.

FIG. 7(a)(b) are a second modified example showing a rear view of the first substrate and a side cross-section of the image sensor portion according to an embodiment. As shown in FIG. 7, the image sensor portion may further include an image signal processing chip 135, an oscillator 138, and at least one or all of an electronic component 139 within the receiving hole 132 of the first substrate 131. The oscillator 138 may be a passive or active oscillator, and may be, for example, a passive oscillator such as X-Tal. The electronic component 139 may include a passive component or an active component, and may include, for example, a plurality of capacitors. The oscillator 138 and the electronic component 139 may be electrically connected to the main substrate 125 through the receiving hole 132 of the first substrate 131. Therefore, the oscillator 138 and the electronic component 139 for SerDes operation may be disposed on the outside of the image signal processing chip 135 and may be electrically connected to the main substrate 125. As shown in FIG. 6(a), the capacitors of the memory 136 and the electronic component 137 may be placed on one side of the receiving hole 132. As shown of FIG. 7(a), the capacitors of the memory 136 and electronic components 137 may be disposed on one side of the receiving hole 132, and the capacitors may be placed between at least two sides of the receiving hole 132 and the image signal processing chip 135.

FIG. 8(a) is a perspective view of the camera module, and FIG. 8(b)(c) is drawings comparing image sensors mounted on the main substrate. A connector 155 is attached to the rear of the camera module, and an image sensor 121 is attached to the front. The image sensor 121 and 121A may optionally be mounted on the main substrate 125 with various megapixels, such as a 2-megapixel sensor or a 5-megapixel sensor. This allows the image signal processing chip 135 to be directly connected to the rear of the main substrate 125 through the first substrate 131, or other memory or electronic components to be further mounted, so that image sensors of various resolutions from 2 megapixels to 5 megapixels or more may be mounted. The image sensor 121 may be one of a plurality of types of image sensors. That is, the type and size of the image sensor 121 and 121A may vary depending on the specifications of the camera module or the number of pixels. In addition, pins may be formed at positions corresponding to connection terminals configured as a single pin map on one surface of the main substrate 121. Different image sensors may be replaced and connected to the connection terminals configured as a single pin map, and there is no need to manufacture a separate SiP module substrate for each type of image sensor. The SiP module for each pixel of the image sensor may be configured with the same size and the same pin map, so that the substrate of the camera module may be platformed.

According to the present embodiment, the thickness of the first substrate 131 by directly connecting the image signal processing chip 135 to the main substrate 125 may be reduced, and the gap between the first substrate 131 and the second substrate 151 may be reduced, thereby providing a miniaturized camera module. In addition, by modularizing the image sensor 121 and the image signal processing chip 135 into a SiP module, a separate image sensor reinforcement process is not required in the final camera assembly process, thereby simplifying the overall assembly process. In addition, even if the type of image sensor 121 is different, it may be connected to a SiP module substrate configured with the same pin map, so that the SiP module may be platformized.

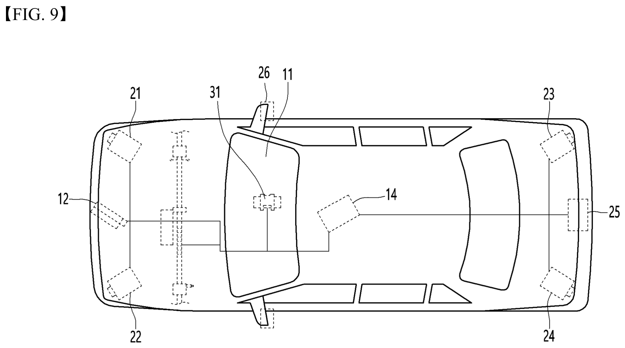

FIG. 9 is an example of a plan view of a vehicle to which a camera module or optical system according to an embodiment of the invention is applied. Referring to FIG. 9, a vehicle camera system according to an embodiment of the invention includes an image generating unit 11, a first information generating unit 12, a second information generating unit 21, 22, 23, 24, 25, and 26, and a control unit 14. The image generating unit 11 may include at least one camera module 31 disposed in the vehicle, and may capture images of the front of the vehicle and/or the driver to generate a front image or an interior image of the vehicle. The image generating unit 11 may capture images of the surroundings of the vehicle in one or more directions as well as the front of the vehicle using the camera module 31, to generate an image of the surroundings of the vehicle. Here, the front image and the surrounding images may be digital images, and may include color images, black and white images, infrared images, etc. In addition, the front image and the surrounding images may include still images and moving images. The image generating unit 11 provides driver images, forward images, and surrounding images to the control unit 14. Next, the first information generating unit 12, which may include at least one radar and/or camera installed in the vehicle, detects the area ahead of the vehicle and generates first detection information. Specifically, the first information generating unit 12 is installed in the vehicle and detects the location and speed of vehicles located in front of the vehicle, the presence and location of pedestrians, and other factors to generate first detection information.

Using the first detection information generated by the first information generating unit 12, the vehicle may be controlled to maintain a constant distance between the vehicle and the preceding vehicle. This can enhance vehicle operation stability in specific, preset situations, such as when the driver changes lanes or when backing up. The first information generating unit 12 provides the first detection information to the control unit 14. The second information generating unit 21, 22, 23, 24, 25, and 26 detects each side of the own vehicle based on the front image generated by the image generating unit 11 and the first detection information generated by the first information generating unit 12 to generate second detection information. Specifically, the second information generating unit 21, 22, 23, 24, 25, and 26 may include at least one radar and/or camera disposed in the own vehicle, and may detect the position and speed of vehicles located on the side of the own vehicle or capture images. Here, the second information generating units 21, 22, 23, 24, 25, and 26 may be disposed at each of the front corners, side mirrors, and the rear center and rear corners of the own vehicle.

At least one information generating unit of these vehicle camera systems may include the optical system and the camera module having the same as described in the above-described embodiments, and may provide or process information acquired through the front, rear, each side, or corner area of the vehicle to a user to enable autonomous driving or to protect the vehicle and objects from surrounding safety. The optical system of the camera module according to the embodiment of the invention may be applied to a camera or sensing device for LiDAR to recognize the surrounding environment of a moving object such as a vehicle in real time. In addition, the camera module according to the embodiment of the invention may be installed in multiple units in a vehicle to enhance safety regulations, autonomous driving functions, and increase convenience by using an Advanced Driving assistance system (ADAS). In addition, the optical system of the camera module is applied in a vehicle as a component for control such as a lane keeping assistance system (LKAS), a lane departure warning system (LDWS), and a driver monitoring system (DMS). The optical system and camera module including the optical system disclosed in the embodiments of the invention can achieve stable optical performance even under ambient temperature changes and provide a cost-competitive module, thereby ensuring the reliability of vehicle components.

The features, structures, and effects described in the embodiments above are included in at least one embodiment of the present invention and are not necessarily limited to a single embodiment. Furthermore, the features, structures, and effects illustrated in each embodiment may be combined or modified in other embodiments by those skilled in the art to which the embodiments pertain. Therefore, such combinations and modifications should be construed as being within the scope of the present invention.

Also, while the embodiments have been described above, they are merely illustrative and not limiting. Those skilled in the art will appreciate that various modifications and applications not illustrated above are possible without departing from the essential characteristics of the embodiments. For example, each component specifically illustrated in the embodiments may be modified and implemented. Furthermore, any differences related to such modifications and applications should be construed as being within the scope of the present invention defined in the appended claims.

## Claims

1. An image sensor module comprising:
an image sensor;
an image signal processing chip interfacing with the image sensor;
a main substrate having one surface on which the image sensor is mounted and the other surface on which the image signal processing chip is mounted;
an adhesive member between the main substrate and the image sensor; and
a first substrate bonded to the other surface of the main substrate,
wherein the first substrate includes a receiving hole extending from the other surface to one surface, and
wherein the image signal processing chip is connected to the other surface of the main substrate through the receiving hole of the first substrate.

2. The image sensor module of claim 1, further comprising:
a memory disposed on one side of the receiving hole,
wherein the memory is connected to the other surface of the main substrate through the receiving hole.

3. The image sensor module of claim 1, further comprising:
an electronic component disposed on at least one side of the receiving hole,
wherein the electronic component is connected to the other surface of the main substrate through the receiving hole.

4. The image sensor module of claim 1, further comprising:
an oscillator disposed on one side of the receiving hole,
wherein the oscillator is connected to the other surface of the main substrate through the receiving hole.

5. The image sensor module of any one of claims 1 to 4,
wherein the image signal processing chip is a serializer IC.

6. The image sensor module of any one of claims 1 to 4,
wherein the image signal processing chip is spaced apart from a lower surface of the first substrate.

7. A camera module comprising:
an image sensor;
an image signal processing chip interfacing with the image sensor;
a main substrate having one surface on which the image sensor is mounted and the other surface on which the image signal processing chip is mounted;
an adhesive member between the main substrate and the image sensor;
a first substrate bonded to the other surface of the main substrate;
a second substrate bonded to the other surface of the first substrate; and
a power module and connector connected to the other surface of the second substrate,
wherein the first substrate includes a receiving hole extending from the other surface to one surface, and
wherein the image signal processing chip is connected to the other surface of the main substrate through the receiving hole of the first substrate.

8. The camera module of claim 7, further comprising:
a lens barrel disposed around an upper periphery of the second substrate and having a plurality of lenses therein.

9. The camera module of claim 7, further comprising:
a memory or an oscillator disposed on one side of the receiving hole,
wherein the memory or oscillator is connected to the other surface of the main substrate through the receiving hole.

10. The camera module of claim 7, further comprising:
an electronic component disposed on at least one side of the receiving hole,
wherein the electronic component is connected to the other surface of the main substrate through the receiving hole.

11. The camera module of claim 7,
wherein the image signal processing chip is a serializer IC, and
wherein the image signal processing chip and the image sensor directly interface through the main substrate.

12. The camera module of any one of claims 7 to 11,
wherein a thickness of the first substrate is greater than a thickness of the main substrate,
wherein a thickness of the second substrate is greater than the thickness of the first substrate,
wherein a length of at least one side of the second substrate is greater than a length of at least one side of the first substrate.
